# EUROPEAN PATENT SPECIFICATION

(11) **EP 3 190 616 B1**
(45) Date of publication and mention of the grant of the patent: **05.09.2018**
(21) Application number: 16155801.0
(22) Date of filing: 16.02.2016
(51) Int. Cl.: F21K 9/232, F21Y 115/10, F21Y 107/00

(54) **A LED LIGHT WITH OMNIDIRECTIONAL LIGHT DISTRIBUTION**
LED-LEUCHTE MIT OMNIDIREKTIONALER LICHTVERTEILUNG
LAMPE À DEL AVEC DISTRIBUTION DE LUMIÈRE OMNIDIRECTIONNELLE

(30) Priority: 06.01.2016 CN 201610002680
(43) Date of publication of application: 12.07.2017
(73) Proprietor: Shandong Prosperous Star Optoelectronics Co., Ltd, Shandong Province (CN)
(72) Inventor: MA, Wenbo, Xintai City (CN); LIAO, Qiurong, Xintai City (CN); KONG, Yiping, Xintai City (CN); YUAN, Xincheng, Xintai City (CN); ZHOU, Minkang, Xintai City (CN)
(74) Representative: Sun, Yiming

(56) References cited:
- EP-A1- 2 535 640
- CN-U- 203 656 652
- US-B1- 8 933 619

## Description

### Technical field

This invention relates to the field of LED light, and more particularly to a LED light with omnidirectional light distribution.

### Background art

Based on energy saving and environmental protection, incandescent light is gradually abandoned by people. Featuring long service life, high lighting effect, no radiation and anti-impact, LED light is replacing incandescent light.

CN 203 656 652 U describes an omnibearing LED (Light Emitting Diode) lamp bulb, which consists of a sealed lightening bulb shell, a sealing part for an opening in the bottom of the sealed lightening bulb shell, a lightening module and a lamp cap which is connected to the bottom of the sealing part, wherein the lightening module is a strip-type LED lamp filament and is vertically mounted above the sealing part; a gas pipe is arranged in the sealing part; the strip-type LED lamp filament is connected with a supply lead contact of the sealing part by a connecting lead; heat dissipation protection gas is filled in the sealed lightening bulb shell. The gas with low viscosity and high thermal conductivity is used for filling for heat dissipation, and the light LED lamp bulb with a 360-degree omnibearing illumination effect and an ideal heat dissipation effect is obtained.

EP 2 535 640 A1 describes a LED light bulb, comprising: a LED light bulb shell; a core column with an exhaust tube and a bracket; at least one LED light emitting strip with LED chips therein emitting 4A light; a driver; and an electrical connector, wherein the LED light bulb shell is vacuum sealed with the core column so as to form a vacuum sealed chamber, which is filled with a gas having a low coefficient of viscosity and a high coefficient of thermal conductivity, the bracket and the LED light emitting strips fixed on the bracket are housed in the vacuum sealed chamber, the LED light emitting strip is in turn electrically connected to the driver, the electrical connector, while the electrical connector is used to be electrically connected to an external power supply, so as to light the LED light emitting strips.

US 8 933 619 B1 describes a kind of lamp holder structure of LED bulb comprising a transparent stem, an upper PCB board with upper mounting hole and a lower PCB board with lower mounting hole while the transparent stem is nested to the upper mounting hole and the lower mounting hole in sequence, a LED tube installed between the upper PCB board and the lower PCB board as well as separately electrically-connected to them. The LED tube can be secured by soldering to the appropriate welding position on the upper and lower PCB board. The transparent stem is equivalent to a fixed support for the upper and lower PCB board. When illuminated, the LED tube lights up and all give out light at 360 degree.

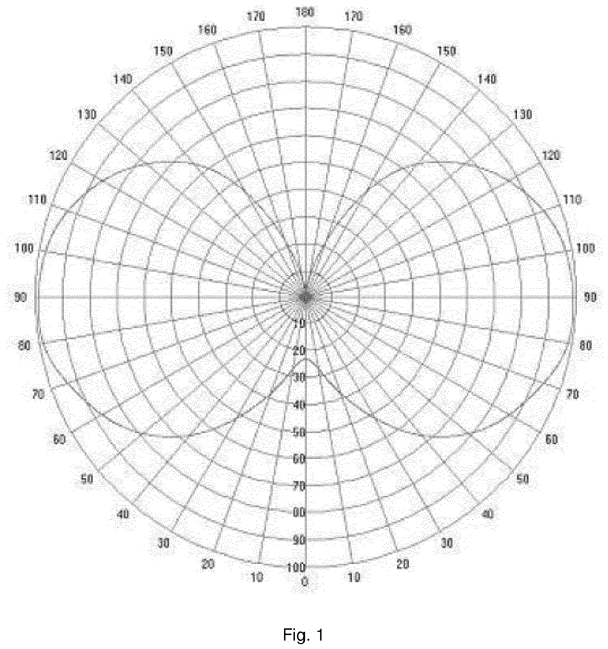

To meet people's reminiscence, LED filament which is made with LED and similar to incandescent light appears nowadays. Due to the limitation of existing LED filament structure and production process, the included angle between LED filament and stem in filament light is relatively small, which makes the light of filament light mainly shines all around. The light intensity at the bottom of bulb shell is relatively weak. The distribution curve fluxes of LED filament in prior art is shown in Fig.1, the light intensity distribution fails to meet the requirements of Energy Star on LED light with omnidirectional light distribution.

### Contents of the invention

To overcome the above shortcomings in prior art, the purpose of this invention is to provide a LED light with omnidirectional light distribution according to the appended claims.

It can be seen from the above technical solutions that this invention has the following advantages.

The magnetic connecting piece used in the stem fixes the bar-type LED filament through magnetic force and plays a conductive and fixing role. The angle between bar-type LED filaments is adjusted by changing the set height of support pillar and the sectional area of magnetic connecting piece, and the distribution curve fluxes of bar-type LED filaments are adjusted to obtain the LED lights with different distribution curve fluxes and make them meet different use requirements. The electrode of bar-type LED filament is connected with the wire by spot welding. The magnetic connecting piece adsorbs the die bond substrate through magnetic force to reduce the frequency of spot welding during production of LED lights with omnidirectional light distribution and greatly improve productivity and yield rate of LED lights.

### Brief description of the drawings

To explain the technical solutions more clearly in this invention, the following is a brief introduction to the attached drawings required for the description. Apparently, the following drawings are only some embodiments in this invention. The ordinary technicians in this field can obtain other drawings based on these drawings without creative work.
Fig. 1 is a diagram for distribution curve fluxes of LED filament in prior art;
Fig. 2 is a diagram for overall structure of the LED light with omnidirectional light distribution;
Fig. 3 is a diagram for an embodiment structure of bar-type LED filament;
Fig. 4 is a diagram for another embodiment structure of bar-type LED filament;
Fig. 5 is a diagram for an embodiment structure of the LED light with omnidirectional light distribution;
Fig.6 is a diagram for distribution curve fluxes of an embodiment of the LED light with omnidirectional light distribution.

### Detailed description of preferred embodiments

To make purpose, characteristics and advantages of this invention more apparent and understandable, the following embodiments and drawings will be used to clearly and completely describe the technical solutions of this invention. Apparently, the following drawings are only some embodiments in this invention but not all the embodiments. Based on the embodiments in this patent, the ordinary technicians in this field can obtain other drawings without creative work. This is within the protection scope of this patent.

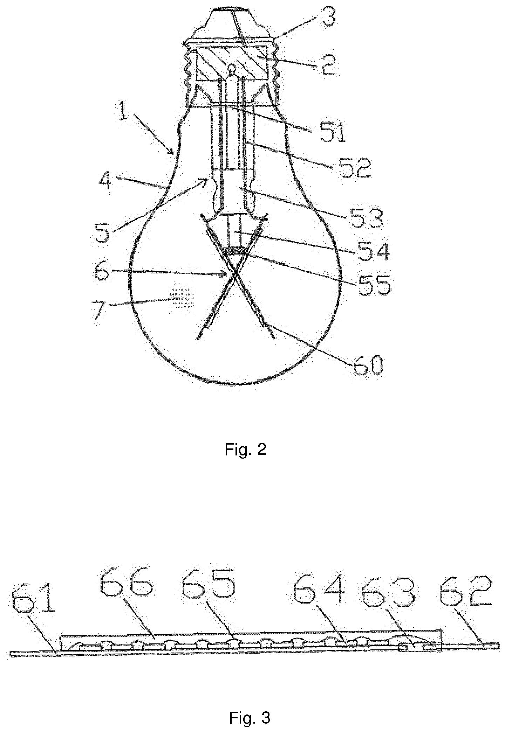

A LED light with omnidirectional light distribution is provided in the embodiment, as shown in Fig.2, comprising a light-emitting bulb 1 and a lamp holder 3 connecting with the light-emitting bulb 1.

The said lamp holder 3 is set with a power driver 2, and external thread is set outside the said lamp holder 3.

The said light-emitting bulb 1 comprises a shell 4, a stem 5 set inside the shell 4 and a light-emitting component 6. One end of the stem 5 is connected with the said power driver 2, and the other end of the stem 5 is connected with the light-emitting component 6. The said stem 5 is set with the wire 52.

The said light-emitting component 6 comprises at least two bar-type LED filaments 60 with omnidirectional glaring. The said bar-type LED filaments 60 are connected in series connection or in series-parallel connection. The said bar-type LED filament 60 is connected with the power driver 2 through the stem wire 52.

In this embodiment, as shown in Fig.3, the said bar-type LED filaments 60 comprises a die bond substrate 61, an electrode 62, a gold bonding wire 65, a fluorescent colloid 66 and several light-emitting chips 64.

Light-emitting chip 64 is attached and fixed onto the front of the die bond substrate 61. The anode and cathode of light-emitting chip 64 is directly or indirectly connected with the anode and cathode of die bond substrate 61 through the gold bonding wire 65. The said anode and cathode are respectively connected with outer leads of the anode and cathode of substrates 61 set on the die bond substrate.

One end of the said electrode 62 is connected with outer leads of the die bond substrate 61 through the gold bonding wire 65 and fixed with the outer lead of the die bond substrate 61 through the plastic cement 63. The other end of the said electrode 62 is connected with the said wire 52.

The fluorescent colloid 66 is filled on the front and back of the die bond substrate 60 through the transparent AB glue (epoxy glue or silicon glue), and covers the light-emitting chip 64.

The said light-emitting chip 64 is purple light wafer, and the said fluorescent colloid is RGB three-color fluorescent powder to make LED filament a white light LED source.

The bar-type LED filament 60 has an integrated package structure which changes the traditional way that die bond is mounted on the metal support. By mounting the die bond on the transparent die bond substrate, the fluorescent colloid 66 is coated on the front and back sides of the die bond substrate (the front side is die bond side, while the back side is non-die bond plane opposite to the front side). This has radically improved the glaring efficiency of LED light source. It is more outstanding for the white light LED source.

The light-emitting chip 64 is a transparent body. After being electrified, the light-emitting chip 64 emits the natural light from six sides. Some light directly penetrates through the transparent die bond substrate 61 and then radiates on the fluorescent colloid 66 at the back of the die bond substrate. Other light directly radiates the surface of the light-emitting chip 64 to have the natural light of the light-emitting chip 64 transferred into the white light.

The said die bond substrate 61 is of conductive magnetic substance, iron, nickel, cobalt or alloy material.

The surface of the said die bond substrate 61 is set with silver-plated or gold-plated coating. The surface of the said electrode 62 is of conductive metal such as iron, nickel, cobalt, copper or alloy.

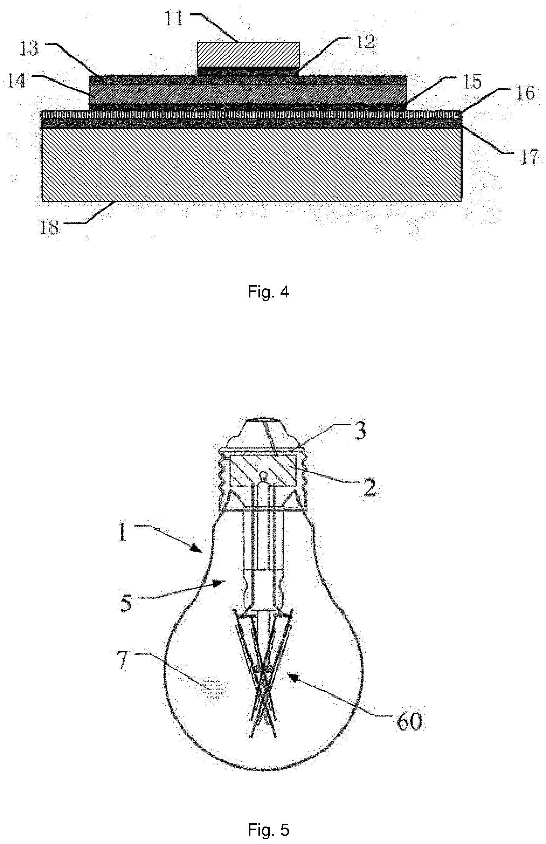

In this embodiment, the bar-type LED filament 60 further comprises another mode of execution. As shown in Fig.4, the said bar-type LED light comprises continuously laminated LED chips 11, interlinked layer 12, ceramic substrate 14, welding layer 15, copper layer 16, insulation layer 17 and heat dissipation layer 18.

The said ceramic layer 14 is a substrate for bar-type LED filament, and the surface of the ceramic layer 14 is plated with a circuit silver layer 13. The said ceramic substrate 14 is set with several LED chips 11, and the LED chips 11 are connected through the interlinked layer 12. The end of the ceramic substrate 14 is set with the outer leads of the anode and cathode connecting with the interlinked layer 12. The outer leads of the anode and cathode are connected with the power driver 2 through the wire 52.

In the structure of this embodiment, copper layer 16 and heat dissipation layer 18 play a role of heat dissipation to make the bar-type LED filament 60 obtain good heat dissipation performance. After the test, the bar-type LED filament 60 can keep on operating for 2,500 hours under 55°C as a constant temperature. Under 70°Cas a constant temperature, it can keep on operating for 1,000 hours, which improves the service life of the LED light with omnidirectional light distribution.

In this embodiment, the stem 5 comprises exhaust tube 51, seal 53, support pillar 54 and magnetic connecting piece 55.

The seal 53 is wrapped outside the wire 52, and the seal 53 is connected with the shell 4. The exhaust tube 51 is set inside the seal 53, and the exhaust tube 51 has the internal part of light-emitting bulb connected with the external part. After the sealing process of the light-emitting bulb 1 is completed, the end of the exhaust tube 51 is welded for sealing.

One end of the support pillar 54 is fixed at the end of the seal 53, while the other end of the support pillar 54 is bonded with the magnetic connecting piece 55. The magnetic connecting piece 55 is used to fix the bar-type LED filament and have the bar-type LED filaments connected through magnetic connecting piece 55. The said magnetic connecting piece 55 is made of conductive NdFeB magnet, Sm-Co magnet, AINiCo magnet or ferrite magnet. This has improved the electrical conductivity of the magnetic connecting piece 55 and enhanced the service life of the LED light with omnidirectional light distribution.

In this embodiment, the electrode 62 of bar-type LED filament is connected with the wire 52 by spot welding. The magnetic connecting piece 55 adsorbs the die bond substrate 61 through magnetic force. In the LED light with omnidirectional light distribution, the angle between bar-type LED filaments is adjusted by changing the set height of support pillar 54 and the sectional area of magnetic connecting piece 55, and the distribution curve fluxes of bar-type LED filaments are adjusted.

The included angle between bar-type LED filament 60 and support pillar 54 goes between 5°∼60°. The range of the preferred included angle goes between 15°∼50°, and the preferred included angles are 25°, 27°, 35°, 45°, 50° and 55°. The included angle between bar-type LED filament 60 and support pillar 54 goes between 25°∼27°. The light source emitting from the LED light with omnidirectional light distribution is relatively concentrated and applicable to being used in the site where the light is relatively concentrated or at some positions in need of concentrated radiation. However, it does not necessary require very concentrated radiation, and the included angle goes between 25°∼27°. As for non-concentrated radiation area, it can play a role of radiation, and there will be no distinct difference for light brightness in the area.

When the included angle is 35° and 45°, the light emitting from the LED light with omnidirectional light distribution is relatively uniform. When the included angle is 50° and 55°, the light emitting from the LED light with omnidirectional light distribution is relatively wide, and it is suitable for being used to radiate a large scope and can ensure uniform light distribution.

In this embodiment, the said light-emitting bulb 1 is filled with heat dissipation and protective gases 7 which comprise, helium, hydrogen, argon, inert gas with low-viscosity and high thermal conductivity as well as any or many of mixed gases. The air pressure of the said heat dissipation and protective gases 7 is 0.2-3 atmosphere in room temperature.

In this embodiment, the said power driver 2 is fixed in the lamp holder 3 with pouring sealant. Light-emitting bulb 1 and lamp holder 3 are bonded with adhesive. Light-emitting bulb 1 and lamp holder 3 are connected through metal part or plastic part. Thus, the lamp holder 3 can hold the power driver 2 with a relatively large volume.

In this embodiment, the model of the said light-emitting bulb 1 includes A-type bulb, G-type bulb, P-type bulb, B-type bulb, C-type bulb or T-type bulb.

The model of the said lamp holder 3 includes E-type lamp holder, B-type lamp holder, GU-type lamp holder, GX-type lamp holder or GZ-type lamp holder.

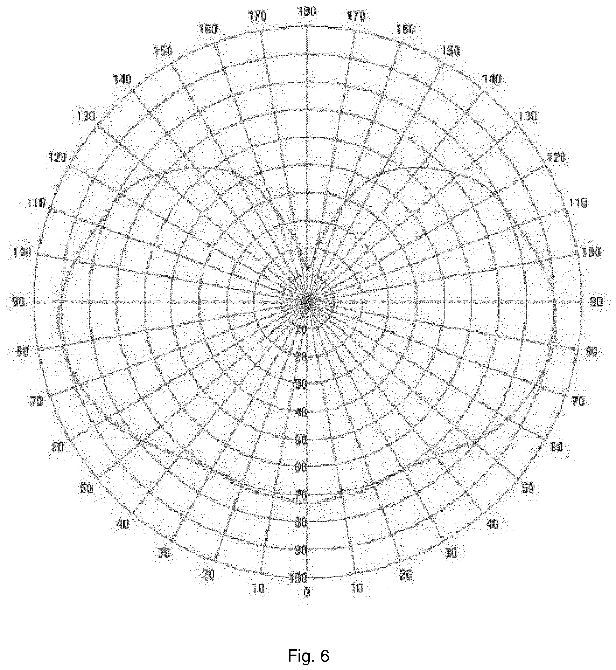

This embodiment provides a preferred embodiment. As shown in Fig. 5 and Fig. 6, the light-emitting bulb 1 is A60 bulb, and the lamp holder 3 is E27 lamp holder.

The said power driver 2 is fixed in the lamp holder 3 with pouring sealant. Light-emitting bulb 1 and lamp holder 3 are bonded with adhesive. Light-emitting bulb 1 and lamp holder 3 are connected through metal part or plastic part. Thus, the lamp holder 3 can hold the power driver 2 with a relatively large volume.

The light-emitting component 6 is composed of four LED filaments 60. The four LED filaments are in series connection by two filaments and then in parallel connection. The two filaments in series connection in the same branch circuit are symmetrically distributed in space. Thus, the light emitting from the light-emitting component 6 is uniform. The included angle between bar-type LED filament 60 and support pillar 54 is 27°. The distribution curve fluxes for omnidirectional light distribution can be obtained in Fig. 6.

Each embodiment in the specifications is described in a progressive manner. Each embodiment is focused on stressing its differences from other embodiments. The same or similar parts among embodies can be referred to each other.

## Claims

1. A LED light with omnidirectional light distribution comprising a light-emitting bulb (1) and a lamp holder (3) connected with the light-emitting bulb;
wherein said lamp holder is set with a power driver, and external thread is set outside the said lamp holder;
wherein said light-emitting bulb comprises a shell (4), a stem (5) set inside the shell and a light-emitting component (6). One end of the stem is connected with the said power driver (2), and the other end of the stem is connected with the light-emitting component. The said stem is set with the wire (52);
wherein said light-emitting component (6) comprises at least two bar-type LED filaments (60) with omnidirectional glaring. The said bar-type LED filaments are connected in series connection or in series-parallel connection. The said bar-type LED filament is connected with the power driver (2) through the stem (5);
wherein said bar-type LED filament comprises a die bond substrate (61), an electrode (62), a gold bonding wire (65), a fluorescent colloid (66) and several light-emitting chips (64);
wherein said light-emitting chip is attached and fixed onto the front of the die bond substrate; the anode and cathode of light-emitting chip is directly or indirectly connected with the anode and cathode of die bond substrate through the gold bonding wire; said anode and cathode are respectively connected with outer leads of the anode and cathode of substrates set on the die bond substrate;
wherein one end of the said electrode is connected with outer leads of the die bond substrate through the gold bonding wire and fixed with the outer lead of the die bond substrate through the plastic cement (63); the other end of the said electrode is connected with the said wire; and
wherein the fluorescent colloid (66) is filled on the front and back of the die bond substrate through the transparent AB glue, and covers the light-emitting chip; said light-emitting chip is purple light wafer, and the said fluorescent colloid is RGB three-color fluorescent powder to make LED filament a white light LED source;
**characterized in that**
the said die bond substrate is of conductive magnetic substance, iron, nickel, cobalt or alloy material.
Preferably, the surface of the said die bond substrate is set with silver-plated or gold-plated coating.
The surface of the said electrode is of conductive metal such as iron, nickel, cobalt, copper or alloy.
The stem comprises exhaust tube (51), seal (53), support pillar (54) and magnetic connecting piece (55).
The seal is wrapped outside the wire, and the seal is connected with the shell. The exhaust tube is set inside the seal, and the exhaust tube has the internal part of light-emitting bulb connected with the external part. The end of the exhaust tube is welded to the sealed light-emitting bulb for sealing.
One end of the support pillar is fixed at the end of the seal, while the other end of the support pillar is bonded with the magnetic connecting piece. The magnetic connecting piece is used to fix the bar-type LED filament and have the bar-type LED filaments connected through magnetic connecting piece.
The said magnetic connecting piece is made of conductive NdFeB magnet, Sm-Co magnet, AINiCo magnet or ferrite magnet.

2. The LED light with omnidirectional light distribution according to Claim 1 **characterized in that** the said bar-type LED filament comprises continuously laminated LED chips (11), interlinked layer (12), ceramic layer (14), welding layer (15), copper layer (16), insulation layer (17) and heat dissipation layer (18).
The said ceramic layer is a substrate for bar-type LED filament, and the surface of the ceramic layer is plated with a circuit silver layer (13). The said ceramic substrate is set with several LED chips, and the LED chips are connected through the interlinked layer. The end of the ceramic substrate is set with the outer leads of the anode and cathode connecting with the interlinked layer.

3. The LED light with omnidirectional light distribution according to Claim 1 **characterized in that** the electrode of bar-type LED filament is connected with the wire by spot welding. The magnetic connecting piece adsorbs the die bond substrate through magnetic force. In the LED light with omnidirectional light distribution, the angle between bar-type LED filaments is adjusted by changing the set height of support pillar and the sectional area of magnetic connecting piece, and the distribution curve fluxes of bar-type LED filaments are adjusted.

4. The LED light with omnidirectional light distribution according to Claim 3 **characterized in that** the included angle between bar-type LED filament and support pillar goes between 5°∼60°.

5. The LED light with omnidirectional light distribution according to Claim 1 **characterized in that** the said light-emitting bulb is filled with heat dissipation and protective gases which comprise, helium, hydrogen, argon, inert gas with low-viscosity and high thermal conductivity as well as any or many of mixed gases. The air pressure of the said heat dissipation and protective gases is 0.2-3 atmosphere in room temperature.

6. The LED light with omnidirectional light distribution according to Claim 1 **characterized in that** the said power driver is fixed in the lamp holder with pouring sealant. Light-emitting bulb and lamp holder are bonded with adhesive. Light-emitting bulb and lamp holder are connected through metal part or plastic part.

7. The LED light with omnidirectional light distribution according to Claim 1 **characterized in that** the model of the said light-emitting bulb includes A-type bulb, G-type bulb, P-type bulb, B-type bulb, C-type bulb or T-type bulb.
The model of the said lamp holder includes E-type lamp holder, B-type lamp holder, GU-type lamp holder, GX-type lamp holder or GZ-type lamp holder.

## Patentansprüche

1. LED-Leuchte mit omnidirektionaler Lichtverteilung, umfassend eine Leuchtbirne (1) und eine Lampenfassung (3), die mit der Leuchtbirne verbunden ist;
wobei die Lampenfassung mit einem Leistungstreiber versehen ist und ein Außengewinde außerhalb der Lampenfassung angeordnet ist;
wobei die Leuchtbirne eine Schale (4), einen Schaft (5), der in der Schale angeordnet ist, und eine lichtemittierende Komponente (6) umfasst. Ein Ende des Schafts ist mit dem Leistungstreiber (2) verbunden, und das andere Ende des Schafts ist mit der lichtemittierenden Komponente verbunden. Der Schaft wird mit dem Draht (52) gesetzt;
wobei die lichtemittierende Komponente (6) mindestens zwei stabförmige omnidirektional leuchtende LED-Leuchtfäden (60) umfasst. Die LED-Leuchtfäden sind in Reihenschaltung oder in Reihenparallelschaltung verbunden. Der stabförmige LED-Leuchtdraht ist über den Schaft (5) mit dem Leistungstreiber (2) verbunden;
wobei der stabförmige LED-Leuchtfaden ein Chipbondsubstrat (61), eine Elektrode (62), einen Goldbonddraht (65), ein fluoreszierendes Kolloid (66) und mehrere lichtemittierende Chips (64) umfasst;
wobei der lichtemittierende Chip an der Vorderseite des Chipbondsubstrats angebracht und befestigt ist; die Anode und Kathode des lichtemittierenden Chips sind direkt oder indirekt mit der Anode und Kathode des Chipbondsubstrats durch den Goldbonddraht verbunden; die Anode und Kathode sind jeweils mit äußeren Vorsprüngen der Anode und Kathode von Substraten verbunden, die auf dem Chipbondsubstrat angeordnet sind;
wobei ein Ende der Elektrode mit äußeren Vorsprüngen des Chipbondsubstrats durch den Goldbonddraht verbunden ist und mit dem äußeren Vorsprung des Chipbondsubstrats durch den Kunststoffzement (63) befestigt ist; das andere Ende der Elektrode ist mit dem Draht verbunden; und
wobei das fluoreszierende Kolloid (66) mit dem transparenten AB-Kleber auf die Vorder- und Rückseite des Chipbondsubstrats gefüllt ist und den lichtemittierenden Chip bedeckt; der lichtemittierende Chip ein Purpurlicht-Wafer ist, und das fluoreszierendes Kolloid ein dreifarbiges RGB-Fluoreszenzpulver ist, um ein LED-Leuchtfaden zu einer Weißlicht-LED-Quelle zu machen;
**dadurch gekennzeichnet, dass**
das Chipbondsubstrat aus einer leitfähigen magnetischen Substanz, einem Eisen-, Nickel-, Kobalt- oder Legierungsmaterial besteht.
Vorzugsweise ist die Oberfläche des Chipbondsubstrats mit einer versilberten oder goldplattierten Beschichtung versehen.
Die Oberfläche der Elektrode aus leitfähigem Metall wie Eisen, Nickel, Kobalt, Kupfer oder Legierung besteht.
Der Schaft ein Abgasrohr (51), eine Dichtung (53), eine Stützsäule (54) und ein magnetisches Verbindungsstück (55) umfasst.
Die Dichtung ist über den Draht gewickelt und die Dichtung ist mit der Schale verbunden. Das Abgasrohr ist innerhalb der Dichtung angeordnet, und das Abgasrohr den inneren Teil der Leuchtbirne mit dem äußeren Teil verbindet. Das Ende des Abgasrohrs ist zur Abdichtung mit der abgedichteten Leuchtbirne verschweißt.
Ein Ende der Stützsäule ist am Ende der Dichtung befestigt, während das andere Ende der Stützsäule mit dem magnetischen Verbindungsstück verbunden ist. Das magnetische Verbindungsstück wird verwendet, um den stabförmigen LED-Leuchtfaden zu befestigen, und die stabförmigen LED-Leuchtfäden durch ein magnetisches Verbindungsstück verbunden sind.
Das magnetische Verbindungsstück besteht aus einem leitfähigen NdFeB-Magneten, Sm-Co-Magneten, AlNiCo-Magneten oder Ferritmagneten.

2. LED-Leuchte mit omnidirektionaler Lichtverteilung nach Anspruch 1, **dadurch gekennzeichnet, dass** der stabförmige LED-Leuchtfaden durchgehend laminierte LED-Chips (11), vernetzte Schicht (12), keramische Schicht (14), Schweißschicht (15), Kupferschicht (16), Isolierschicht (17) und Wärmeableitschicht (18) umfasst.
Die Keramikschicht ist ein Substrat für den stabförmigen LED-Leuchtfaden, und die Oberfläche der Keramikschicht ist mit einer Schaltungssilberschicht (13) plattiert. Das Keramiksubstrat ist mit mehreren LED-Chips bestückt und die LED-Chips sind durch die vernetzte Schicht verbunden. Das Ende des Keramiksubstrats ist so festgelegt, dass die äußeren Vorsprünge der Anode und Kathode mit der vernetzten Schicht verbunden sind.

3. LED-Leuchte mit omnidirektionaler Lichtverteilung nach Anspruch 1, **dadurch gekennzeichnet, dass** die Elektrode des stabförmigen LED-Leuchtfadens durch Punktschweißen mit dem Draht verbunden ist. Das magnetische Verbindungsstück adsorbiert das Chipbondsubstrat durch magnetische Kraft. Bei der LED-Leuchte mit omnidirektionaler Lichtverteilung wird der Winkel zwischen LED-Stäben vom Stabtyp durch Ändern der eingestellten Höhe der Stützsäule und der Querschnittsfläche des magnetischen Stutzens eingestellt, und die Verteilungskurvenflüsse von LED-Stäben vom Stabtyp werden eingestellt.

4. LED-Leuchte mit omnidirektionaler Lichtverteilung nach Anspruch 3, **dadurch gekennzeichnet, dass** der eingeschlossene Winkel zwischen dem stabförmigen LED-Leuchtfaden und der Stützsäule zwischen 5 ° ∼ 60 ° beträgt.

5. LED-Leuchte mit omnidirektionaler Lichtverteilung nach Anspruch 1, **dadurch gekennzeichnet, dass** die Leuchtbirne mit wärmeableitenden und Schutzgasen gefüllt ist, die Helium, Wasserstoff, Argon, Inertgas mit niedriger Viskosität und hoher Wärmeleitfähigkeit umfassen ebenso wie einige oder viele gemischte Gase umfassen. Der Luftdruck der wärmeableitenden und Schutzgase beträgt 0,2-3 Atmosphäre bei Raumtemperatur.

6. LED-Leuchte mit omnidirektionaler Lichtverteilung nach Anspruch 1, **dadurch gekennzeichnet, dass** der Leistungstreiber in der Lampenfassung mit einem gießbaren Dichtungsmittel befestigt ist. Leuchtbirne und Lampenfassung sind mit Klebstoff verklebt. Leuchtbirne und Lampenfassung sind durch ein Metallteil oder Kunststoffteil verbunden.

7. LED-Leuchte mit omnidirektionaler Lichtverteilung nach Anspruch 1, **dadurch gekennzeichnet, dass** das Modell der lichtemittierenden Lampe eine A-Typ-Birne, G-Typ-Birne, P-Typ-Birne, B-Typ-Birne, C-Typ-Birne oder T-Typ-Birne ist.
Das Modell der Lampenfassung umfasst eine E-Typ-Lampenfassung, eine B-Typ-Lampenfassung, eine GU-Typ-Lampenfassung, eine GX-Typ-Lampenfassung oder eine GZ-Typ-Lampenfassung.

## Revendications

1. Eclairage LED avec distribution de lumière omnidirectionnelle comprenant une ampoule émettrice de lumière (1) et un support de lampe (3) connecté à l'ampoule émettrice de lumière ;
dans lequel ledit support de lampe est posé avec un dispositif de commande d'alimentation électrique et un filetage extérieur est placé à l'extérieur dudit support de lampe ;
dans lequel ladite ampoule émettrice de lumière comprend une enveloppe (4), une tige (5) placée à l'intérieur de l'enveloppe et un composant émetteur de lumière (6), une extrémité de la tige est connectée audit dispositif de commande d'alimentation électrique (2) et l'autre extrémité de la tige est connectée au composant émetteur de lumière, ladite tige est posée avec le fil (52) ;
dans lequel ledit composant émetteur de lumière (6) comprend au moins deux filaments LED de type barre (60) avec lumière éblouissante omnidirectionnelle, lesdits filaments LED de type barre sont connectés en connexion en série ou en connexion en série-parallèle, ledit filament LED de type barre est connecté avec le dispositif de commande d'alimentation électrique (2) par l'intermédiaire de la tige (5) ;
dans lequel ledit filament LED de type barre comprend un substrat de liaison (61), une électrode (62), un fil de liaison à l'or (65), un colloïde fluorescent (66) et plusieurs puces émettrices de lumière (64) ;
dans lequel ladite puce émettrice de lumière est rattachée et fixée sur l'avant du substrat de liaison ; l'anode et la cathode de la puce émettrice de lumière est connectée directement ou indirectement avec l'anode et la cathode du substrat de liaison par l'intermédiaire du fil de liaison à l'or ; ladite anode et cathode sont respectivement connectées avec des conducteurs électriques externes de l'anode et la cathode des substrats placés sur le substrat de liaison ;
dans lequel une extrémité de ladite électrode est connectée avec des conducteurs électriques externes du substrat de liaison par l'intermédiaire du fil de liaison à l'or et fixée avec le conducteur électrique externe du substrat de liaison par l'intermédiaire du ciment plastique (63) ; l'autre extrémité de ladite électrode est connecté avec ledit fil ; et
dans lequel le colloïde fluorescent (66) est rempli sur l'avant et l'arrière du substrat de liaison par l'intermédiaire de la colle AB transparente et couvre la puce émettrice de lumière ; ladite puce émettrice de lumière est une plaquette de lumière violette, et ledit colloïde fluorescent est une poudre fluorescente tricolore RGB afin de faire du filament LED une source LED de lumière blanche ;
**caractérisé en ce que**
ledit substrat de liaison est d'une substance magnétique conductrice, du fer, nickel, cobalt ou matériau d'alliage,
de préférence, la surface dudit substrat de liaison est prévue avec un revêtement plaqué argent ou plaqué or,
la surface de ladite électrode est en un métal conducteur tel que le fer, nickel, cobalt, cuivre ou alliage,
la tige comprend un tube d'échappement (51), un joint d'étanchéité (53), un pilier de soutien (54) et une pièce de connexion magnétique (55),
le joint d'étanchéité est enveloppée à l'extérieur du fil et le joint d'étanchéité est connecté avec l'enveloppe, le tube d'échappement est placé à l'intérieur du joint d'étanchéité et le tube d'échappement a la partie interne de l'ampoule émettrice de lumière connectée avec la partie externe, l'extrémité du tube d'échappement est soudé à l'ampoule émettrice de lumière étanchéifiée à des fins d'isolation étanche,
une extrémité du pilier de soutien est fixée à l'extrémité du joint d'étanchéité, alors que l'autre extrémité du pilier de soutien est liée avec la pièce de connexion magnétique, la pièce de connexion magnétique est utilisée pour fixer le filament LED de type barre et avoir les filaments LED de type barre connectés par l'intermédiaire d'une pièce de connexion magnétique,
ladite pièce de connexion magnétique est constituée d'un aimant conducteur NdFeB, aimant Sm-Co, aimant AlNiCo ou aimant ferrite.

2. Eclairage LED avec distribution de lumière omnidirectionnelle selon la revendication 1, **caractérisé en ce que** ledit filament LED de type barre comprend des puces LED stratifiées en continu (11), une couche entrelacée (12), une couche céramique (14), une couche de soudage (15), une couche de cuivre (16), une couche d'isolation (17) et une couche de dissipation thermique (18),
ladite couche céramique est un substrat pour filament LED de type barre, et la surface de la couche céramique est plaquée avec une couche argentée de circuit (13), ledit substrat céramique est pourvue de plusieurs puces LED et les puces LED sont connectées par l'intermédiaire de la couche entrelacée, l'extrémité du substrat céramique est placée avec les conducteurs électriques externes de l'anode et la cathode connectant avec la couche entrelacée.

3. Eclairage LED avec distribution de lumière omnidirectionnelle selon la revendication 1, **caractérisé en ce que** l'électrode du filament LED de type barre est connecté avec le fil par soudage par points, la pièce de connexion magnétique absorbe le substrat de liaison par l'intermédiaire de la force magnétique, dans l'éclairage LED avec distribution de lumière omnidirectionnelle, l'angle entre des filaments LED de type barre est ajusté en variant la hauteur de pose du pilier de soutien et la zone sectionnelle de la pièce de connexion magnétique et les flux de courbe de distribution des filaments LED de type barre sont ajustés.

4. Eclairage LED avec distribution de lumière omnidirectionnelle selon la revendication 3, **caractérisé en ce que** l'angle inclus entre le filament LED de type barre et le pilier de soutien est compris entre 5°∼60°.

5. Eclairage LED avec distribution de lumière omnidirectionnelle selon la revendication 1, **caractérisé en ce que** ladite ampoule émettrice de lumière est remplie avec des gaz protecteurs et de dissipation thermique qui comprennent de l'hélium, hydrogène, argon, gaz inerte avec faible viscosité et haute conductivité thermique ainsi que n'importe lequel ou plusieurs de gaz mélangés, la pression d'air desdits gaz protecteurs et de dissipation thermique est 0.2-3 atmosphère dans la température de la pièce.

6. Eclairage LED avec distribution de lumière omnidirectionnelle selon la revendication 1, **caractérisé en ce que** ledit dispositif de commande d'alimentation électrique est fixé dans le support de lampe en versant un mastic d'étanchéité, l'ampoule émettrice de lumière et le support de lampe sont liés avec une colle, l'ampoule émettrice de lumière et le support de lampe sont connectés par l'intermédiaire d'une pièce métallique ou une pièce plastique.

7. Eclairage LED avec distribution de lumière omnidirectionnelle selon la revendication 1, **caractérisé en ce que** le modèle de ladite ampoule émettrice de lumière inclut une ampoule de type A, ampoule de type G, ampoule de type P, ampoule de type B, ampoule de type C ou ampoule de type T, le modèle dudit support de lampe inclut un support de lampe de type E, support de lampe de type B, support de lampe de type GU, support de lampe de type GX ou support de lampe de type GZ.
